# EUROPEAN PATENT APPLICATION

(11) **EP 0 606 776 A2**
(43) Date of publication of application: **20.07.1994**
(21) Application number: 93310612.2
(22) Date of filing: 30.12.1993
(51) Int. Cl.: H01L 31/09, H01L 33/00

(54) **Terahertz radiation emission and detection**

(30) Priority: 14.01.1993 GB 9300627
(71) Applicant: HITACHI EUROPE LIMITED, Maidenhead, Berkshire, SL6 8YA (GB)
(72) Inventor: White, Julian Darryn, Histon, Cambridge, CB4 4HY (GB)
(74) Representative: Read, Matthew Charles

(57) **Abstract**

A terahertz optical emission device comprises a substrate (3) with first and second electrodes (1, 2) one overlying the other with LT-GaAs dielectric material between them. When a femtosecond laser pulse is applied, terahertz radiation is produced in the plane of the substrate. A corresponding terahertz radiation detector is disclosed, together with a sensor system which uses an emitter and detector for detecting and sensing an operational parameter of a system under test.

## Description

This invention relates to a terahertz optical emission device, a detecting device for such radiation, and a sensing device.

Terahertz radiation has been produced hitherto by applying ultra-short laser pulses to biased dielectric material. Terahertz radiation pulses are generated by allowing a short laser pulse to be incident on the gap between a pair of charged strip lines separated by a semiconductor such as semi-insulating GaAs. If the wavelength of the laser light is above the band-gap of the GaAs, electron-hole pairs are generated which create a conducting path between the two lines, allowing current to flow. The sudden rise in the current between the conductors causes a large amount of radiation to be given off, caused by the sudden acceleration of the photo- generated carriers by the strong electric which exists in the gap region. The radiation has a characteristic frequency in the region of 1 terahertz and was first observed by Fattinger et al [Ch. Fattinger and D. Grischowsky, Appl. Phys. Lett., 53, 1480 (1989)]. For a full review of THz beam optics see Martin van Exter and Daniel R. Grischowsky, IEEE Transactions on Microwave Theory and Techniques, 38, 1684 (1990).

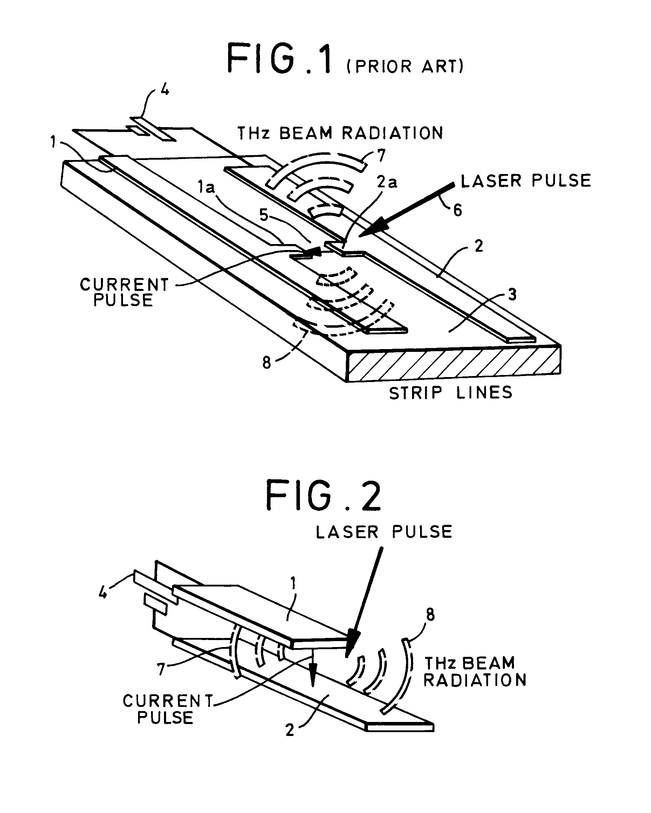

An example of such a prior art arrangement will be described herein with reference to Figure 1 of the accompanying drawings wherein two conductive lines 1, 2 are formed with facing protrusions 1 a, 2a on the surface of a substrate 3. This arrangement is charged by a voltage source 4. The material in region 5 between the protrusions 1 a, 2a of the conductive lines is a dielectric, typically semi-insulating GaAs forming at least a part of the substrate 3.

To generate a terahertz pulse, an ultra short laser pulse is directed to the dielectric in region 5, as shown by arrow 6. The laser source (not shown) typically produces pulses of the order of 50fs. The effect of the rapid rise time of the laser pulse is to perturb the dielectric such that a current pulse flows between the protrusions 1 a, 2a, which in turn results in the emission of terahertz radiation. The current pulse flows in the plane of the surface of the substrate 3 and so the bulk of the resulting terahertz radiation radiates down into the substrate and vertically upwards (as shown in the drawing by references 7, 8). Furthermore, the polarisation of the radiation is parallel to the surface of the semiconductor substrate 3. This direction of the terahertz radiation has the disadvantage that the radiation cannot readily be captured within the semiconductor substrate. It would be desirable to channel the radiation along the substrate so that it can be used for test purposes on other structures formed thereon. However, the prior art configuration requires special optical devices to be attached to the substrate in order to reflect the radiation in a direction parallel to the substrate.

In order to overcome these problems, the present invention provides a terahertz optical emission device comprising a substrate, means on the substrate defining first and second spaced apart electrodes with dielectric material disposed therebetween, means for applying an electrical voltage to the electrodes, and means for applying a pulse of laser radiation to the dielectric material such that the pulse of radiation causes terahertz optical radiation to be produced in the dielectric material, characterised in that the electrodes are disposed one overlying the other with a layer of the dielectric material disposed therebetween.

The layer which separates the two conductors is most suitably some semiconductor with a high dark resistivity and high breakdown strength, characteristics which are well demonstrated by a material called low-temperature GaAs (LT-GaAs). This will be discussed in more detail hereinafter.

The invention also provides an optical detecting device comprising a substrate, means on the substrate defining first and second spaced apart electrodes with dielectric material disposed therebetween, means for applying an electrical voltage to the electrodes, and detection circuitry connected to the electrodes, operative to detect an electrical signal produced in response to terahertz optical radiation being directed at the dielectric material, characterised in that the electrodes are disposed one overlying the other and with a layer of the dielectric material disposed therebetween.

The invention also includes an optical sensing device including the aforementioned emission device and detecting device, and a system under test, the system, in response to a change in an operational parameter thereof, changing its characteristics presented to incident terahertz radiation, the sensing device being so arranged that terahertz optical radiation is directed from the emission device to the system under test, and terahertz radiation passes from the system to the detecting device such that the output of the detection circuitry is a function of the operational parameter of the system under test.

In one example, the system under test is operative as a sensor responsive to an external ambient condition.

In order that the invention can be more fully understood, an embodiment thereof will now be described by way of example with reference to the accompanying drawings in which:
Figure 1 is a schematic illustration of the prior art arrangement described hereinbefore;
Figure 2 is a schematic perspective view of a terahertz emission device in accordance with the invention, for illustrating the principles of operation;
Figure 3 is a more detailed, sectional view of the device shown in Figure 2;
Figure 4 is a sectional view of a detecting device in accordance with the invention;
Figure 5 illustrates a modification for the devices of Figures 3 and 4; and
Figure 6 illustrates schematically an optical sensing device in accordance with the invention wherein a terahertz emitter and detector in accordance with the invention are integrated into a semiconductor circuit for sensing inter sub-band transitions in a HEMT circuit structure.

Referring to Figure 2, instead of the electrodes 1, 2 being placed side by side on a substrate, as shown in Figure 1, the electrodes are disposed one overlying the other so as to sandwich a dielectric layer (not shown in Figure 2) between them. The thickness of the dielectric layer is chosen to be of the same order as the absorption depth of the laser light so that the laser pulse will create carriers throughout the full depth of the dielectric layer, electrically connecting the charged electrodes. The resulting current pulse is thus oriented vertically as shown in the drawing travelling from the top electrode 1 to the bottom electrode 2. A pulse in the opposite direction can of course be achieved by reversing the polarity of the voltage from source 4. The polarisation of the resulting pulse of terahertz radiation is oriented perpendicular to the planes of the electrodes and thus when the device is formed on a substrate, the bulk of the radiation can travel along the plane of the substrate.

This difference provides two major benefits when using the terahertz radiation for absorption spectroscopy. The first is that the radiation is generated in a direction which can be conveniently captured i.e. along the plane of the substrate, instead of being radiated vertically upwards and downwards. Thus, the radiation can be captured using in-plane waveguides formed on the substrate without the need for external components such as silicon lenses stuck onto the top surface or underneath of the chip. The second benefit is that the radiation has a polarisation suitable for inducing inter sub-band transitions in nanofabricated structures such as quantum wells and laterally patterned devices on the substrate. This property, coupled with the high intensity of the terahertz being radiation facilitates extremely sensitive measurements of the electronics transitions in small electronic devices.

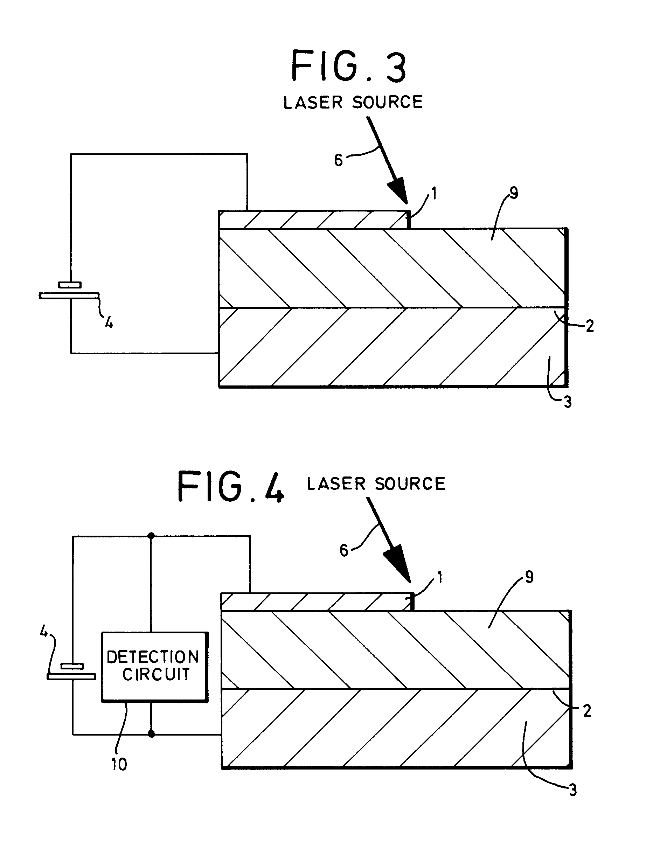

These advantages can be seen more clearly from Figure 3 which illustrates schematically a section through a device manufactured in accordance with the principles shown in Figure 2. In this example, the underlying electrode 2 is formed by a n + or p semiconductor wafer, onto which is grown an insulating dielectric layer 9. The upper electrode 1 is formed by a stage of optical or electron-beam lithography and a stage of metalisation in manner that will be readily apparent to those skilled in the art. It will thus be appreciated that the terahertz radiation, produced in response to an applied laser pulse 6, will be produced primarily in the plane of the surface of the substrate 3 with its plane of polarisation parallel to that of the semiconductor surface.

The laser light should be able to penetrate uniformly from the face of the structure to the bottom electrode 2, whilst depositing most of the pulse energy within the dielectric layer 9. This implies that the optimum thickness for the dielectric layer 9 is 1-2 times the absorption depth of the particular wavelength of the laser light in the dielectric material 9.

The material chosen for the dielectric must be of extremely high resistance in its normal-off-state in order to facilitate charging of the electrodes 1, 2. Conversely, the resistance of the material in the on-state (when a laser pulse is applied) should be as low as possible.

The material 9 should have a high carrier mobility in order that the photo-generated electron-hole pairs produced by the laser pulse are swept out of the region between the electrodes 1, 2 by the electric field therebetween, in as short a time as possible. This property is important for the generational efficiency of terahertz radiation. This consideration is also to a large extent governed by the spacing of the electrodes and therefore should be taken into consideration when assessing the optimum thickness of the substrate, but as a general rule, a higher value of mobility will lead to improved performance.

These requirements can be amply satisfied by using low temperature GaAs (LT-GaAs) as the material for the dielectric layer 9. This material is a derivative of normal stoichiometrically perfect GaAs grown by molecular beam epitaxy at a lower temperature, for example 200 °C, than that usually considered appropriate to from perfect GaAs (600 _{°} C). Under these conditions, the grown layer contains one percent excess arsenic. When the resulting epitaxial layer is subsequently annealed for example at 600 °C for approximately 10 minutes, the excess arsenic gathers together in clumps which are a few nanometers in diameter, surrounded by stoichiometric GaAs of high quality.

For the first criterion of good switch performance requiring high unilluminated resistivity LT-GaAs, has an extremely high resistivity even for background doping densities of up 10-¹⁸_{CM}-³. This is probably due to the As small forming spherical Shottky depletion regions, turning the material semi-insulating even for very high doping densities. It has also been found that sometimes it appears to have a larger avalanch breakdown strength than ordinary GaAs, which enables a larger voltage to be applied across the switch.

The second criterion of requiring a high mobility, is also to a large extent fulfilled by LT-GaAs as 99 percent of the material is GaAs of good crystalline quality. Therefore, the material has mobilities approaching that of stoichiometrically correct GaAs and are certainly much higher than those found in amorphous materials or ion damaged semiconductors.

A structure similar to that shown in Figures 2 and 3 can be used as a terahertz radiation detector. Referring to Figure 4, the substrate 3 forms an electrode structure 2 with an overlying layer of LT-GaAs material 9, onto which a metallic electrode structure 1 is formed. The voltage source 4 applies a bias between the electrodes 1, 2. Additionally, a detector circuit 10 is provided to detect voltage fluctuations between the electrodes. In use, incident terahertz radiation induces a time varying voltage on the electrodes 1 and 2 which is detected by the circuitry 10. Thus, a convenient form of in-plane detector can be provided for the terahertz radiation. Again, LT-GaAs material is suitable for use as a dielectric layer 9. The high density of As globules leads to a large number of effective recombination centres and thus the life time of photogenerated carriers in the material is <1ps which is much less than the few nano-seconds found in stoichiometric GaAs. It is important that the lifetime of the carriers is of the same order or less than the width of the incident pulse of terahertz radiation as the time varying voltage induces extra current between the strip lines which is added to the current generated by voltage source, 4. The current pulse generated by the incident laser pulse effectively "samples" the current generated by the terahertz pulse.

As an alternative method for constructing the vertically disposed switches, LT-GaAs can be lifted off in thin sheets by a process known as epitaxial lift-off which was recently devised by Yablonovitch et al [E. Yablonovitch, D.M. Hwang, T.J. Gmitter, L.T. Florez and J. Harbison, Appl. Phys. Lett., 56, 2419 (1991)]. In this method, epitaxial layers of GaAs are deposited on very thin layers of AlAs during growth. The samples are then immersed in weak HF solution which preferentially attacks the AlAs. In this case the layers grown on top of the AlAs are floated off, where these layers can be anything from a simple layer of GaAs to a fully functional High Electron Mobility Transistor (HEMT) layer structure. The floated-off films can then be deposited on any smooth substrate from crystalline silicon to amorphous glass, and fortuitously it has been demonstrated that the layer sticks to the substrate with great tenacity due to Van-der Waals forces, obviating the need for an intermediate sticking agent.

Thus, in a second method of construction of the device as shown in Figures 3 and 4, epitaxial grown LT-GaAs can be grown by an epitaxial lift-off process and then deposited on a metallic substrate with the top contact 1 being formed by the same method as previously described. This process, although more complex, may lead to a reduction in the contact resistance, as the use of a metal substrate for the electrode 2 is superior to heavily doped semiconductor (as previously described) in terms of conductivity. In both cases, thin layers of LT-GaAs can be formed, with thicknesses down to only a few tens of nanometers in order to optimise the performance.

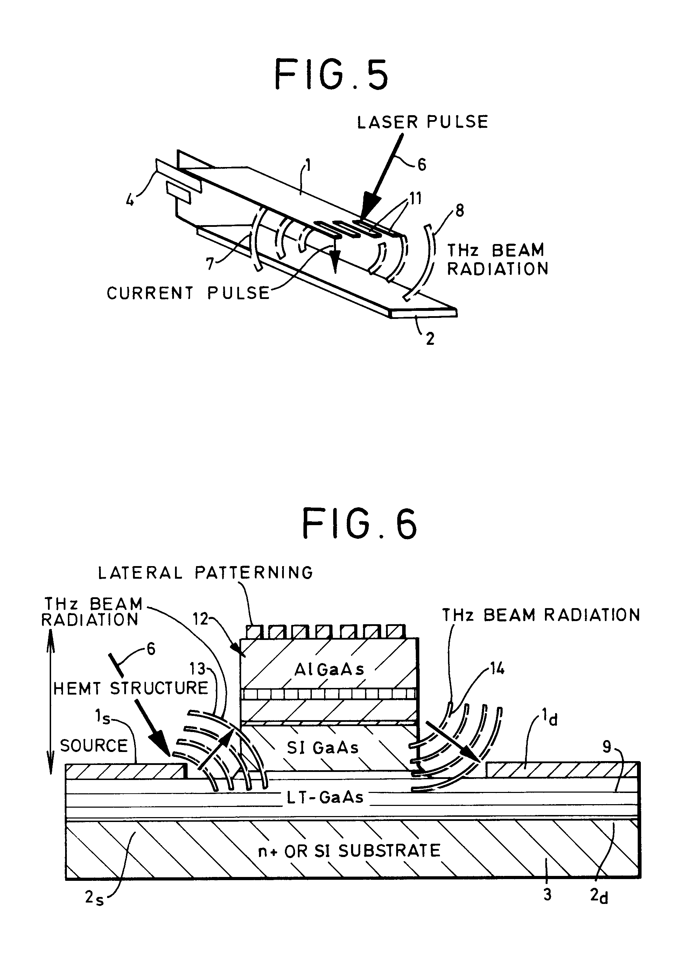

A modification of the design of top electrode 1 is shown in Figure 5, which is applicable both to the emitter and detector of Figures 3 and 4. It is considered that the effect of the incident laser pulse 6 produces electron-hole pairs in the dielectric material between the electrodes 1, 2 primarily as a result of the high field effect which occurs in the edge of the electrode 1. An increased edge length can be achieved by providing a digitated contact pattern by means of fingers 11 formed on the contact 1. This can be thought of as creating a greater amount of illuminated edge so reducing the contact resistance. If the digitations 11 are made of a sufficiently fine pitch, they can act as a diffraction grating for the incident laser pulse creating a more uniform illumination of the dielectric material underneath the electrode 1.

As an alternative to the previously described metal contacts 1, a transparent conducting material could be used, i.e. substantially transparent to the visible or near infra-red radiation produced by the laser source. A suitable material would be indium- tin-oxide - see Wook Seo et al, IEEE Photonics Technology Letters 4, 888 (1992). This would enable most of the energy contained in the laser pulse to be absorbed in the underlying dielectric material, leading to enhanced responsivity.

From the foregoing, it will be seen that terahertz beam radiation produced by the emitters previously described can readily be coupled into laterally patterned waveguides formed on the surface of the semiconductor substrate 3. The simplest waveguide for such radiation would be a channel of high refractive index material (e.g. GaAs) surrounded by low refractive index material e.g. air. The approximate wavelength for radiation of 2 terahertz in air is 150 microns. In GaAs the wavelength would be a fraction of this due to its high refractive index. Therefore, such waveguides can conveniently be made using optical lithography. Another possibility for constructing waveguides of low loss would be to use the method of epitaxial lift-off described hereinbefore to deposit a laterally patterned waveguide on the surface of a low-refractive index dielectric material such as glass or quartz. This would enable a terahertz beam of radiation to be transmitted around a circuit from point to point with low loss.

Referring now to Figure 6, this shows how a source and emitter according to Figures 3 and 4 can be integrated into other electronic devices, for example to form a sensing system. LT-GaAs material forms a good buffer layer for the subsequent growth of high quality transistor material and so the transistor structure, the terahertz source and detector can all be formed on a common substrate.

Thus, referring to in detail to Figure 6, a layer of LT-GaAs material 9 is formed on a substrate 3, typically n + GaAs and an overlying metallisation layer 1 is provided, patterned by lithography, to define a source electrode 1 and a detector electrode 1d. A HEMT structure 12 is formed between the source and detector electrodes 1 s, 1 d. The HEMT structure will not be described in detail and reference is directed to our co-pending applications GB 9100136.2 and 9125727.9 for details of exemplary structures. However, typically the devices will include a GaAs/AIGaAs interface defining a two dimensional electron gas, which is modulated by an overlying electrode structure. As will be apparent from our prior applications, such devices can be used to control transition of electron states for a number of different purposes. Operation of such devices gives rise to inter sub-band transitions of electron states, which can be conveniently sensed by terahertz optical spectroscopy. Thus in the arrangement shown in Figure 6, the HEMT structure 12 constitutes a system under test wherein incident terahertz radiation 13 produced by a laser pulse 6 is selectively absorbed depending on the inter sub-band transitions that occur in the HEMT structure. After the terahertz radiation 13 has passed through the structure 12 and has selectively absorbed thereby, it passes as beam 14 to the detector 1 d, 2d which is coupled to a detection circuit 10 as described with reference to Figure 4, so that operational characteristics of the HEMT structure can be detected by terahertz optical spectroscopy. This provides a valuable tool for analysing operation of such quantum structures during operation.

Also, it will be appreciated that the HEMT structure may be responsive to an external ambient condition, for example pressure, temperature or incident radiation. Thus, the device of Figure 6 could be used to detect such ambient conditions.

## Claims

1. A terahertz optical emission device comprising:
a substrate (3);
means on the substrate defining first and second spaced apart electrodes (1, 2) with dielectric material disposed therebetween;
means (4) for applying an electrical voltage to the electrode; and
means for applying a pulse of laser radiation
(6) to the dielectric material such that the pulse
of radiation causes terahertz optical radiation to
be produced in the dielectric material;
characterised in that the electrodes (1, 2) are disposed one overlying the other with a layer of the dielectric material (9) disposed therebetween.

2. A device according to claim 1 wherein the electrodes (1, 2) are generally planar and disposed in planes parallel to the surface of the substrate (3).

3. A device according to claim 1 or 2, wherein the dielectric material (9) comprises LT-GaAs.

4. A device according to any preceding claim wherein the substrate (3) forms one of said electrodes (2) and the dielectric material (9) is grown on the substrate.

5. A device according to any one of claims 1 to 3, wherein the dielectric material is formed separately and thereafter deposited on the substrate.

6. A device according to any preceding claim wherein at least one of said electrodes (1) is defined by lithography.

7. A device according to any preceding claim wherein at least one of said electrodes is at least partially transparent to said laser radiation.

8. A device according to any preceding claim including waveguide means formed on the substrate to direct the terahertz radiation in the plane of the waveguide.

9. A terahertz optical detecting device comprising:
a substrate (3);
means on the substrate defining first and second spaced apart electrodes (1, 2) with dielectric material disposed therebetween;
means (4) for applying an electrical voltage to the electrodes;
and detection circuitry (10) connected to the electrodes operative to detect an electrical signal produced in response to terahertz optical radiation being directed up the dielectric material;
characterised in that the electrodes are disposed one overlying the other with a layer of the dielectric material (9) disposed therebetween.

10. A device according to claim 9 wherein said dielectric material (9) comprises LT-GaAs material.

11. A device according to claim 10 or 11 including waveguide means in the plane of the substrate to direct the terzhertz radiation to the electrodes.

12. An optical sensing device including; a emission
device according to any one of claims 1 to 7;
a detecting device according to claim 9 or 10;
and a system under test, said system in response to a change in operational parameter thereof, changing its characteristics presented to incident terahertz radiation;
the sensing device being so arranged that terahertz optical radiation is directed from the emission device to the system under test, and the terahertz radiation passes from the system to the detecting device such that the output of the detection circuitry is a function of the operational parameter of the system under test.

13. An optical sensing device according to claim 12 wherein said system under test is a sensor responsive to an external ambient condition.
